# EUROPÄISCHE PATENTSCHRIFT

(11) **EP 1 157 429 B1**
(45) Veröffentlichungstag und Bekanntmachung des Hinweises auf die Patenterteilung: **23.01.2008**
(21) Anmeldenummer: 00906294.4
(22) Anmeldetag: 08.02.2000
(51) Int. Cl.: H01L 39/12, C04B 35/45

(54) **SUPRALEITENDE KÖRPER AUS ZINKDOTIERTEM KUPFEROXIDMATERIAL**
SUPERCONDUCTIVE BODIES MADE OF ZINC-DOPED COPPER OXIDE MATERIAL
CORPS SUPRACONDUCTEURS CONSTITUES D'UN MATERIAU A BASE D'OXYDE DE CUIVRE DOPE AU ZINC

(30) Priorität: 17.02.1999 DE 19906748; 24.03.1999 DE 19913213; 13.09.1999 DE 19943838
(43) Veröffentlichungstag der Anmeldung: 28.11.2001
(73) Patentinhaber: Solvay Infra Bad Hönningen GmbH, 30173 Hannover (DE)
(72) Erfinder: PARK, Jai, Won, D-37085 Göttingen (DE); KÖHLER, Karl, D-31100 Diekholzen (DE); HARDINGHAUS, Ferdinand, D-53557 Bad Hönningen (DE); GABEL, Hans, D-53546 Kasbach-Ohlenberg (DE); KRABBES, Gernot, D-01809 Heidenau (DE); SCHÄTZLE, Peter, D-01099 Dresden (DE); STÖVER, Gudrun, D-01239 Dresden (DE)
(74) Vertreter: Vande Gucht, Anne
(86) Internationale Anmeldenummer: PCT/EP2000/000980
(87) Internationale Veröffentlichungsnummer: WO 2000/049665

(56) Entgegenhaltungen:
- EP-A- 0 292 385
- BICHILE G K ET AL: "Enhanced flux pinning by Zn substitution in YBa2Cu3O7-delta" SUPERCONDUCTOR SCIENCE & TECHNOLOGY, UK, Bd. 4, Nr. 2, Februar 1991 (1991-02), Seiten 57-61, XP002137585 ISSN: 0953-2048
- AFFRONTE M ET AL: "High-temperature relaxation processes in Zn and Fe doped tetragonal YBCO" PHYSICA C: SUPERCONDUCTIVITY, ELSEVIER SCIENCE, NETHERLANDS, Bd. 234, Nr. 1-2, 1. Dezember 1994 (1994-12-01), Seiten 91-98, XP002137586
- TOME-ROSA C ET AL: "Impurity pinning in epitaxial YBa2(Cu1-xTMx)3O7-delta(TM=Zn, Ni)-thin films" IEEE TRANSACTIONS ON APPLIED SUPERCONDUCTIVITY, USA, Bd. 3, Nr. 1, März 1993 (1993-03), Seiten 1468-1471, XP002137587 ISSN: 1051-8223
- NKUM R K ET AL: "Substitution of 3d metals for Cu in (Bi,Pb)2Sr2Ca2Cu3Oy" PHYSICA C: SUPERCONDUCTIVITY, ELSEVIER SCIENCE, NETHERLANDS, Bd. 202, Nr. 3-4, 15. November 1992 (1992-11-15), Seiten 371-378, XP002137588 ISSN: 0921-4534
- SKAKLE J M S: "Crystal chemical substitutions and doping of YBa2Cu3Ox and related superconductors" MATERIALS SCIENCE AND ENGINEERING R: REPORTS, ELSEVIER SEQUOIA, CH, Bd. 23, Nr. 1, 15. Juni 1998 (1998-06-15), Seiten 1-40, XP004130213 ISSN: 0927-796X
- PATENT ABSTRACTS OF JAPAN vol. 013, no. 158 (C-586), 17. April 1989 (1989-04-17) & JP 63 315566 A (HITACHI METALS LTD), 23. Dezember 1988 (1988-12-23)

## Beschreibung

Die Erfindung bezieht sich auf supraleitende Körper basierend auf Cuprat, ein für seine Herstellung verwendbares Pulver und die Verwendung der Körper.

Der Begriff "supraleitfähige Körper auf Basis von Cupratmaterial" bezeichnet in dieser Erfindung all jene oxidischen Keramiken (als Formkörper, in Schichtform, auf Bändern oder Substraten aufgebracht, als Draht, in "powder-in-tube-"-Form oder als Target in Beschichtungsverfahren verwendet), die CuO enthalten und bei ausreichend tiefer Temperatur supraleitende Eigenschaften aufweisen.

Supraleitende Körper, z. B. Formkörper, können beispielsweise für kryomagnetische Anwendungen bei höheren äußeren Magnetfeldern eingesetzt werden. Beispielsweise kann es sich um supraleitende Drähte oder Bauteile in Elektromotoren handeln. In Abhängigkeit von der Stärke des äußeren Magnetfeldes wurde beobachtet, daß die kritische Stromdichte um so stärker abfällt, je größer das äußere Magnetfeld ist. Aufgabe der vorliegenden Erfindung ist es, supraleitfähige Körper auf Basis von Cupratmaterial mit einer erhöhten kritischen Stromdichte bei Anwesenheit äußerer Magnetfelder anzugeben. Diese Aufgabe wird durch die erfindungsgemäßen Körper auf Basis von Cupratmaterial gelöst.

Die erfindungsgemäßen supraleitfähigen Körper auf Basis von Cupratmaterial sind gekennzeichnet durch einen Gehalt an Zink-Kationen von 50 bis 5000 ppm. Üblicherweise liegt das Zink in Form des Oxids vor. Bevorzugt sind Körper mit einem Gehalt an Zink-Kationen im Bereich von 100 bis 1000 ppm. Dabei bezieht sich diese Angabe des Gewichtsbereichs vorzugsweise auf die supraleitfähige Phase im Körper (Hilfsmaterial wie besondere Zusätze, Füllmaterial, Targets und eventuelle Zwischenschichten, andere Träger oder (Silber)Rohre in powder-in-tube-Körpern werden dann nicht mitgerechnet).

Generell weisen Körper auf Basis von Cupratmaterial mit dem erfindungsgemäßen Zink-Kationengehalt die Vorteile der Erfindung auf. Bevorzugtes Cupratmaterial ist Cupratmaterial vom Seltenerdemetall-Erdalkalimetall-Cuprat-Typ, insbesondere Yttriumbariumcuprat, sowie Cupratmaterial des Bismut(Blei)-Erdalkalimetall-Kupferoxid-Typs. Diese Materialien sind an sich bekannt; gut geeignete Materialien wurden eingangs bereits genannt. Insbesondere brauchbar ist Bismut-Strontium-Calcium-Cuprat mit einem Atomverhältnis von 2:2:1:2 und 2:2:2:3, wobei bei dem letzteren ein Teil des Bismuts durch Blei ersetzt werden kann. Auch die Wismut-Strontium-Calcium-Cuprate mit Abwandlungen in der Stöchiometrie der vorgenannten Atomverhältnisse sind natürlich brauchbar.

Supraleitendes Cupratmaterial und die Art der Formgebung (Schichtbildung, Schmelztexturierung etc.) sind an sich bekannt.

Beispielsweise gut brauchbar sind Seltenerdmetall-Erdalkalimetall-Cuprate, wie sie in der WO 88/05029 beschrieben werden, insbesondere YBa₂Cu₃O₇₋ₓ ("YBCO"); Bismut(Blei)-Erdalkalimetall-Cuprate, wie Bismut-Strontium-Calcium-Cuprate und Bismut-Blei-Strontium-Calcium-Cuprate, insbesondere vom 2212-Typ (Bi:Sr:Ca:Cu = 2:2:1:2) und vom 2223-Typ (Bi:Sr:Ca:Cu = 2:2:2:3), wobei hier ein Teil des Bi durch Blei ersetzt sein kann. Bi-haltige Cuprate werden z. B. beschrieben in: EP-A 0 336 450, DE-OS 37 39 886, EP-A 0 330 214, EP-A 0 332 291 und EP-A 0 330 305.

Die Überführung der Rohmaterialien (Metalloxide oder Carbonate) in supraleitendes Pulver ist bekannt.

In der deutschen Patentschrift DE 42 16 545 C1 ist ein solches Verfahren offenbart. Das Material wird einer mehrstufigen Temperaturbehandlung bis auf eine Aufheiztemperatur von 950 °C erwärmt und dann wieder abgekühlt.

Es lassen sich verschiedenartige Körper erzeugen, beispielsweise Formkörper, insbesondere durch Schmelztexturieren. Die internationale Patentanmeldung WO 97/06567 offenbart eine Yttriumbariumcuprat-Mischung, die sich besonders für die Herstellung schmelzprozessierter Hochtemperatursupraleiter mit hoher Levitationskraft eignet. Wichtig bei jener Mischung ist, daß weniger als 0,6 Gew.-% freies, nicht in der Yttriumbariumcuprat-Phase gebundenes Kupferoxid sowie weniger als 0,1 Gew.-% Kohlenstoff enthalten sind. Beim Schmelztexturierverfahren werden Zusätze beigegeben, welche "Pinning"-Zentren bilden oder ihre Bildung fördern. Diese Zentren ermöglichen eine Erhöhung der kritischen Stromdichte im Supraleiter. Als "Fluxpinning" fördernde Zusätze sind beispielsweise Y₂BaCuO₅, Y₂O₃, PtO₂, Ag₂O, CeO₂, SnO₂, ZrO₂, BaCeO₃ und BaTiO₃. Diese Zusätze können in einer Menge von 0,1 bis 50 Gew.-% zugesetzt werden. Dabei ist das Yttriumbariumcuprat-Pulver als 100 Gew.-% gesetzt. Platinoxid beispielsweise wird zweckmäßig in einer Menge von 0,5 bis 5 Gew.-% zugesetzt.

Andere Körper sind beispielsweise Dünnschichten, siehe DE-OS 38 26 924 (Abscheidung aus homogener Lösung), Dickschichten in Bandform oder Drahtform mit Zwischenschicht durch Calcinierung einer auf den Träger aufgebrachten Vorläufer-Phase (EP-A 0 339 801), Schichtabscheidung durch PVD-Verfahren (EP-A 0 299 870), CVD-Verfahren (EP-A 0 388 754), Draht in Form einer keramikpulvergefüllten Metallröhre (powder-in-tube-Technik), DE-OS 37 31 266.

Einen Glaskeramik-Formkörper offenbart die EP-A 0 375 134, einen aus der Schmelze erstarrten Gußkörper die EP-A 0 362 492.

Zink-Kationen haben sich als entscheidend wichtig erwiesen. Bei jenen supraleitenden Materialien, z.B. solchen vom Seltenerdmetall-Erdalkalimetall-Cuprat, bei denen nicht bereits als Gitterbaustein Strontium, Calcium und/oder Aluminium enthalten sind (wie z.B. in Bi, Pb-Sr-Ca-Cupraten), sind vorteilhaft zusätzlich durch Zn Zinkkationen auch noch weitere Fremdmetallionen enthalten, nämlich Strontium, Calcium und/oder Aluminium. Bei diesen Fremdmetallionen handelt es sich um Ionen anderer Metalle als denjenigen, die, wie bereits beschrieben wurde, als "Flux-pinning"-Zusatz beigegeben werden.

Die Erfindung betrifft einen Formkörper gemäß Anspruch 1.

Die Erfindung wird im folgenden an einer bevorzugten Ausführungsform, nämlich Körper auf Basis von Yttriumbariumcuprat, weiter erläutert.

Strontium ist zweckmäßig in einer Menge von 100 bis 200 ppm enthalten, Calcium in einer Menge von 30 bis 100 ppm. Der Gehalt an Aluminum liegt vorzugsweise im Bereich von 2 bis 100 ppm vorzugsweise 2 bis 10 ppm. Die gesamte Menge an Zink-Strontium-Calcium- und Aluminium-Kationen beträgt maximal 5500 ppm, vorzugsweise maximal 1200 ppm.

Die erfindungsgemäßen Körper können in verschiedenster Weise ausgebildet sein. Sie können beispielsweise schichtförmig vorliegen. Hierbei kann es sich um Schichten auf flexiblen Bändern oder Drähten handeln, auf Platten oder einkristallinen Substraten. Gegebenenfalls können Pufferschichten zwischen Träger und supraleitfähiger Schicht gemäß der Erfindung angeordnet sein. Bei den Schichten kann es sich um Dünnschichten oder Dickschichten handeln. Ihre Erzeugung ist möglich durch elektrophoretische Abscheidung, durch "dip coating", durch Flüssigphasenepitaxie, Sprühpyrolyse, Sputtern, Laserablation, Metallverdampfung oder CVD-Verfahren. Einige besonders gut geeignete Methoden sind in den eingangs genannten Schriften erläutert. Eine andere Form, in welcher die erfindungsgemäßen supraleitfähigen Körper vorliegenden können, ist das "Pulver im Rohr" (powder-in-tube). Hierbei liegt das erfindungsgemäße Material in Pulverform innerhalb eines Metallröhrchens (beispielsweise aus Silber) vor. Es handelt sich um flexible, drahtähnliche Gebilde.

Gemäß Erfindung liegt der Körper als Formkörper vor. Diese Formkörper werden durch Schmelztexturierung erhalten.

Eine weitere Aufgabe der Erfindung besteht darin, supraleitende Formkörper bereitzustellen, deren kritische Stromdichte auf einem besonders hohen Niveau unabhängig vom äußerem Magnetfeld über einen größeren Bereich konstant ist.

Die Aufgabe wird dadurch gelöst, daß die oben beschriebenen, erfindungsgemäßen Formkörper einer gezielten O₂-Behandlung unterzogen werden. Erfindungsgemäß werden die Formkörper bei einer Temperatur von 300 bis 570 °C 50 bis 200 Stunden in einer reinen O₂-Atmosphäre oder in einem Inertgemisch (z.B. N₂ oder Edelgas) mit einem O₂-Gehalt von 0,1 bis 20 Gew.-% erhitzt und danach langsam abgekühlt. Dies ist eine bevorzugte Ausführungsform der Erfindung.

Die Erfindung wird nun anhand der erfindungsgemäßen Ausführungsform, durch Schmelztexturierung erhaltene Formkörper, weiter erläutert. Das Schmelztexturierungsverfahren ist an sich bekannt. Siehe die WO 97/06567, DE-OS 196 23 050 und GB-A 2 314 076. Man geht aus von Cuprat-Pulver. Das Pulver kann in an sich bekannter Weise durch vermischen der Oxide, Hydroxide oder Carbonate der gewünschten Metalle erzeugt werden.

Zink-Kationen in einer Menge von 50 bis 5000 ppm, ja in einer Menge von 50 bis 7500 ppm vorzugsweise 100 bis 1000 ppm enthaltendes Cuprat-Pulver, insbesondere Yttriumbariumcuprat-Pulver und Bismut(Blei)-Strontium-Calcium-Cuprat-Pulver (2:2:1:2-Typ und 2:2:2:3-Typ) ist ebenfalls Gegenstand der Erfindung. Es hat sich als vorteilhaft erwiesen, wenn das erfindungsgemäße Pulver eine Korngrößenverteilung aufweist, bei welchem 90 % aller Partikel einen Durchmesser unterhalb von 35 µm aufweisen. Der Gehalt an Zink-Kationen im Cupratpulver kann bis 7500 ppm betragen, falls noch Zusätze wie Fluxpinning-Material eingebracht werden.

Die Erfindung, wird im folgenden anhand durch Schmelztexturieren von Yttriumbariumcuprat-Pulver erzeugter Formkörper, weiter erläutert.

Das vorzugsweise bereits die Zink-Kationen (und gegebenenfalls Sr-, Ca- und/der Al-Ionen) enthaltende YBa₂Cu₃O₇₋ₓ-Pulver kann in an sich bekannter Weise in Formkörper umgewandelt werden. Dabei wird es üblicherweise verpreßt und geformt, d. h., es erfährt eine kompaktierende Formgebung.

Das Pulver kann in an sich bekannter Weise durch Vermischen von Yttriumoxid, Bariumoxid und Kupferoxid oder deren Formkörpern erzeugt werden. Gewöhnlich verwendet man das Yttrium in Form des Yttriumoxids, das Kupfer in Form des Kupferoxids und das Barium in Form des Bariumcarbonats.

Die Formkörper gemäß der Erfindung werden hergestellt, indem man das erfindungsgemäße Pulver mit dem gewünschten Fluxpinning-Zusatz vermischt, das Pulver gegebenenfalls vermahlt, um die gewünschte Korngröße zu erreichen, und dann einer Temperaturbehandlung unterzogen. Zweckmäßig wird hierzu das Pulvermaterial zu Grünlingen uniaxial gepreßt. Anschließend erfolgt die Schmelztexturierung.

Die erfindungsgemäßen Körper, insbesondere die erfindungsgemäßen Formkörper, weisen als Vorteil eine wesentlich höhere und über einen großen Bereich konstante kritische Stromdichte auf als zum Vergleich hergestellte Körper mit allenfalls geringem Gehalt (< 50 ppm) an Zink-Kationen, wen auf die Körper ein äußeres Magnetfeld wirkt. Die höhere kritische Stromdichte macht sich bereits bei geringen Feldstärken, beispielsweise im Bereich von 0 bis 1 Tesla bemerkbar. Die erfindungsgemäßen Körper weisen im Bereich der Feldstärke von 0 bis 5 Tesla, vorzugsweise 0,1 bis 4 Tesla des äußeren Magnetfeldes eine annähernd konstante Stromdichte auf einem sehr hohen Niveau auf. Die Levitationskraft ist sehr hoch. Es hat sich bei Reihenversuchen herausgestellt, daß ein weiterer Vorteil der Anwesenheit von Zink-Kationen (und gegebenenfalls weiteren, oben genannten Fremdmetallionen wie Strontium oder Calcium) in einer sehr viel geringeren Streuung in den Eigenschaften der einzelnen Proben liegt (Levitationskraft, Remanenzinduktion, Stromdichte).

Aufgrund der erhöhten konstanten kritischen Stromdichte bei Anwesenheit eines äußeren magnetischen Feldes, sei es im Bereich von 0 bis 5 Tesla oder vorzugsweise von 0,1 bis 4 Tesla, eignen sich die erfindungsgemäßen Körper sehr gut für die industrielle Anwendung. Das Material eignet sich beispielsweise generell für Stromzuführungen, stromleitende Kabel oder zur Anwendung für Pole in Elektromotoren.

Material vom 2-2-1-2-Typ eignet sich beispielsweise für die Herstellung von Kurzschlußstrombegrenzern, Hochfeldmagneten und Stromzuführungen. Material vom 2-2-2-3-Typ eignet sich beispielsweise für die Herstellung von Stromtransportkabeln, Transformatoren, SMES (Supraleitende Magnetische Energie-Speicher), Wicklungen für Elektromotoren, Generatoren, Hochfeldmagneten, Stromzuführungen und Kurzschlußstrombegrenzer. Ein Vorteil ist beispielsweise, daß diese Bauteile kompakter ausgeführt sein können und eine höhere Effizienz aufweisen, als dies bisher möglich war.

Die folgenden Beispiele sollen die Erfindung anhand von YBCO-Material weiter erläutern, ohne sie in ihrem Umfang einzuschränken.

Allgemeine Herstellvorschrift für schmelztexturierte Formkörper:
a) Herstellung des Pulvers:
Yttriumoxid, Bariumcarbonat und Kupferoxid wurden in Quantitäten eingesetzt, so daß das Atomverhältnis von Yttrium, Barium und Kupfer auf 1:2:3 eingestellt war. Die Fremdmetallionen wurden dem Kupferoxid-Ausgangsmaterial zugesetzt und so in das Pulver eingebracht. Die Ausgangsprodukte wurden homogenisiert und verpreßt. Dann wurden sie in einer Temperaturbehandlung dekarbonatisiert. Hierzu wurden sie langsam auf eine Endtemperatur von 940°C gebracht, mehrere Tage bei dieser Temperatur gehalten und dann allmählich abgekühlt. Anschließend wurde das erhaltene Produkt gebrochen und in einer Strahlmühle zerkleinert. Es wurde anschließend erneut verpreßt und wiederum, im Sauerstoffstrom, einer Temperaturbehandlung unterworfen. Es wurde langsam auf 940 °C erhitzt und mehrere Stunden bei dieser Temperatur gehalten. Anschließend ließ man es langsam auf Umgebungstemperatur erkalten. Es wurde gebrochen, abgesiebt und das abgesiebte Feinmaterial in einer Kugelmühle trockengemahlen. Der d_{90%}-Wert (Korngrößenverteilung bestimmt im Cilas-Laser-Granulometer) lag für alle Proben unterhalb von 30,5 µm. Die folgende Tabelle gibt quantitative Analysendaten für den Strontiumgehalt, Calciumgehalt und den Zinkgehalt von drei erfindungsgemäßen Proben (Proben 1 bis 3) und einer Referenzprobe (Probe 4) wieder.

**Tabelle 1: Quantitative Analyse der YBa₂Cu₃O₇₋ₓ-Ausgangspulver bezüglich Fremdmetallionen (Masse-ppm)**

| **Proben-Nr.** | **Sr** | **Ca** | **Al** | **Zn** | **sonstige (Na, Sl, Fe, Bi, Pb, Zr, Ni, Co)** | **Summe** |
|---|---|---|---|---|---|---|
| **1** | 158 | 59 | 10 | 295 | 144 | 666 |
| **2** | 117 | 43 | 05 | 295 | 12 | 580 |
| **3** | 125 | 41 | 09 | 300 | 125 | 600 |
| **4** | 166 | 20 | 27 | 003 | 09 | 306 |

Das Pulver wurde mit 12 Gew.-% Y₂O₃ und 1 Gew.-% Pt-Pulver als Fluxpinning-Zusätze erneut unter Vermahlen homogenisiert. Aus dem Pulver wurden Grünlinge mit einem Durchmesser von 30 mm und einer Höhe von 18 mm uniaxial gepreßt. Die Grünlinge wurden unter Argonatmosphäre bis zur Schmelzprozessierung aufbewahrt.

Zu Beginn der Schmelzprozessierung wurden auf die Grünlinge orientierte Keime von Samariumbariumcuprat aufgelegt. Grünlinge aller drei zu untersuchenden Proben 1 bis 3 wurden zusammen mit den Grünlingen aus der Vergleichsprobe 4 gleichzeitig in der homogenen Temperaturzone eines Reaktionsofens zur Kristallisation gebracht (Schmelztexturierung). Nach der Schmelztexturierung wurden die gebildeten Yttriumbariumcuprat-Monolithe mit Sauerstoff beladen. Sie wurden dann an der Oberseite geschliffen und poliert.

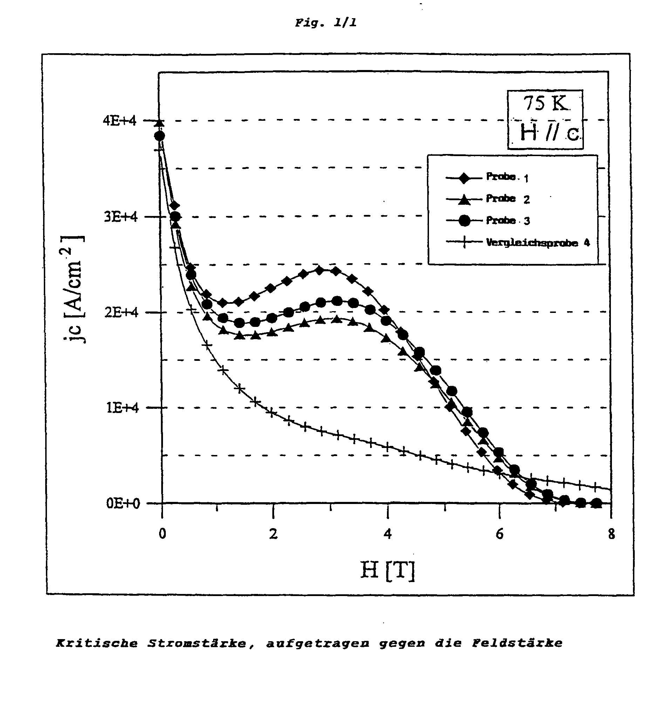

Die kritische Stromdichte (j_{c}) in Abhängigkeit eines externen Magnetfeldes wurde bei 75 K an kleinen Proben (Durchmesser = 4 mm, Höhe = 2 bis 3 mm) bestimmt, die aus den Yttriumbariumcuprat-Monolithen herausgebohrt wurden. Anschließend wurde die kritische Stromdichte bei zunehmend stärkeren Feldstärken eines äußeren Magnetfeldes (von 0 bis 8 Tesla) bestimmt. Die Meßpunkte sind in Figur 1 wiedergegeben, in welcher die kritische Stromdichte gegen das äußere Magnetfeld aufgetragen ist. Die Meßpunkte von Figur 1 zeigen folgendes: Die Vergleichsprobe 4 zeigt eine kontinuierliche Abnahme der kritischen Stromdichte bei zunehmendem äußeren Magnetfeld. Die erfindungsgemäßen Proben 1 bis 3 zeigen im Bereich bis etwa 1,5 Tesla eine, kontinuierliche, jedoch im Unterschied zur Vergleichsprobe geringere Abnahme der kritischen Stromdichte. Bei den erfindungsgemäßen Proben steigt die kritische Stromdichte ab 1,5 Tesla wieder an, bis sie bei 3 Tesla einen Maximalwert erreicht. Bei weiter steigenden Feldstärken fällt auch bei den erfindungsgemäßen Proben der Wert für die kritische Stromdichte langsam ab. Bis zu einer Feldstärke von 6 Tesla liegt er jedoch stets über dem Wert für die Vergleichsprobe 4.

### Allgemeine Vorschrift zur Herstellung sauerstoffbehandelter Monolithen:

Die erfindungsgemäße Beladung der Monolithe mit Sauerstoff erfolgt in einer Ausführungsform dadurch, daß die Formkörper bei einer Temperatur zwischen 480 und 520 °C über einen Zeitraum von 50 Stunden, vorzugsweise 100 bis 200 Stunden in einer reinen O₂-Atmosphäre erhitzt werden und anschließend abgekühlt werden.

In einer anderen Ausführungsform der Erfindung erfolgt die O₂-Behandlung der Formkörper bei einer Temperatur zwischen 300 und 500 °C, wenn anstelle der reinen O₂-Atmosphäre ein Inertgasgemisch, das neben N₂, Ar oder anderen inerten Gasen O₂ in einer Konzentration zwischen 0,1 und 20 Gew.-% enthält, verwendet wird.

Formkörper, in denen zusätzlich zu dem erhöhten Zn-Gehalt ein teilweiser Ersatz des Yttriums durch zweiwertige Kationen z.B. Sr, Ca, Mg vorgenommen wurde, werden vorteilhafterweise bei einer um jeweils 30 bis 50 °C höheren Temperatur als den obengenannten Temperaturen mit O₂ bzw. mit dem O₂-haltigen Gasgemisch erhitzt und anschließend abgekühlt.

Es ist ebenfalls im Sinne der Erfindung, daß die Formkörper zunächst bis zu 100 Stunden bei einer Temperatur von 550 bis 600 °C gehalten werden. Die Formkörper werden entweder auf diese Temperatur aufgeheizt oder nach der Schmelzprozessierung auf diese Temperatur abgekühlt. Danach werden die so vorbehandelten Formkörper wie oben beschrieben der Sauerstoffbehandlung unterzogen.

Die kritische Stromdichte (j_{c}) in Abhängigkeit eines externen Magnetfeldes wurde auch bei den sauerstoffmodifizierten Monolithen bei 75 K an klienen Proben (Durchmesser = 4 mm, Höhe = 2 bis 3 mm) bestimmt, die aus den Yttriumbariumcuprat-Monolithen herausgebohrt wurden. Anschließend wurde die kritische Stromdichte bei zunehmend stärkeren Feldstärken eines äußeren Magnetfeldes (von 0 bis 8 Tesla) bestimmt.

Es wurde gefunden, daß durch die erfindungsgemäße gezielte O₂-Behandlung die kritische Stromdichte bei zunehmendem äußeren Magnetfeld über einen großen Bereich auf einem sehr hohen Niveau konstant bleibt, unabhängig vom angelegten äußeren Magnetfeld.

Aufgrund dieser verbesserten Eigenschaften sind die erfindungsgemäßen Pulver bzw. Formkörper insbesondere die sauerstoffmodifizierten, für Anwendungen, in denen Strom in Anwesenheit eines äußeren Magnetfeldes geleitet werden soll, besonders gut geeignet.

## Patentansprüche

1. Supraleitfähiger, durch Schmelztexturierung erhaltener Formkörper auf Basis von Cuprat Material, **gekennzeichnet durch** einen Gehalt an Zink-Kationen von 50 bis 5.000 Masse-ppm.

2. Supraleitfähiger Körper nach Anspruch 1, **gekennzeichnet durch** einen Gehalt an Zink-Kationen im Bereich von 100 bis 1.000 Masse-ppm.

3. Supraleitfähiger Körper nach Anspruch 1 oder 2, **gekennzeichnet dadurch, dass** das Cuprat-Material Seltenerdmetall-Bariumcuprat-Material oder Bismut (Blei)-Erdalkalimetall Kupferoxid-Material ist.

4. Supraleitfähiger Körper nach Anspruch 3, **dadurch gekennzeichnet, dass**, sofern das Cuprat-Material Seltenerdmetall-Bariumcuprat-Material ist, zusätzlich Strontium-Kationen und/oder Calcium-Ionen enthalten sind.

5. Supraleitfähiger Körper nach Anspruch 1 bis 4, **dadurch gekennzeichnet, dass** Aluminium-Kationen in einer Menge von 2 bis 100 Masse-ppm, vorzugsweise 5 bis 10 Masse-ppm, enthalten sind.

6. Supraleitfähiger Körper nach Anspruch 4 oder 5, **dadurch gekennzeichnet, dass** der Gehalt an Zink-Kationen und Strontium-Kationen, Calcium-Kationen und/oder Aluminium Kationen maximal 1.200 Masse-ppm beträgt.

7. Methode zur Herstellung eines sauerstoffbehandelten supraleitfähigen, durch Schmelztexturierung erhaltenen Formkörpers nach Anspruch 1 bis 6, **dadurch gekennzeichnet, dass** der Formkörper bei einer Temperatur von 300 bis 570°C 50 bis 200 Stunden in einer reinen Sauerstoffatmosphäre oder in einem Inertgasgemisch, das 0,1 bis 20 Gew.-% Sauerstoff enthält, erhitzt und der erhitzte Formkörper anschließend langsam abgekühlt wird.

8. Methode nach Anspruch 7, **dadurch gekennzeichnet, dass** der Formkörper bei einer Temperatur zwischen 480 und 520°C mindestens 50 Stunden, vorzugsweise 100 bis 200 Stunden, in einer reinen Sauerstoffatmosphäre erhitzt wird.

9. Methode nach Anspruch 7, **dadurch gekennzeichnet, dass** der Formkörper bei einer Temperatur von 300 bis 500°C in einem Inertgasgemisch, in dem 0,1 bis 20 Gew.-% Sauerstoff enthalten sind, erhitzt wird.

10. Methode nach Anspruch 7, **dadurch gekennzeichnet, dass** der Formkörper vor der Sauerstoffbehandlung bis zu 100 Stunden bei einer Temperatur von 550 bis 600°C gehalten wird.

11. Supraleitfähiger Körper nach einem der vorgehenden Ansprüche, ausgebildet als Target.

12. Verfahren zur Herstellung von Supraleiter-Material nach Anspruch 1 bis 6, **dadurch gekennzeichnet, dass** ein Cuprat-Pulver mit einem Gehalt an Zink-Kationen in einer Menge von 50 ppm bis 1.000 Masse-ppm und mit einer Korngrößenverteilung, bestimmt nach dem CILAS-Laser-Granulometer, von d₉₀% unterhalb von 35 µm, schmelztexturiert wird.

13. Verfahren nach Anspruch 12, **dadurch gekennzeichnet, dass** der Cuprat-Pulver es sich um YBa₂Cu₃O₇₋ₓ-Pulver oder um Bismut (Blei) Erdalkalimetall-Kupferoxid-Pulver handelt.

14. Verwendung von Körpern nach einem der Ansprüche 1 bis 6 oder hergestellt nach einem der Ansprüche 7-10, für die Herstellung supraleitender Kabel, Permanent Magneten, Kurzschlußstrombegrenzer, Transformatoren, Generatoren, SMES, Schwungmassen-Energiespeicher, Hochfeldmagneten, Elektromagneten oder supraleitende Magnetlager.

## Claims

1. Superconducting molded body, obtained by melt texturing on the basis of a cuprate material, **characterized in that** said body has a zinc cation content of 50 to 5.000 ppm by weight.

2. Superconducting body according to claim 1, **characterized in that** said body has a zinc cation content in a range from 100 to 1.000 ppm by weight.

3. Superconducting body according to claim 1 or 2, **characterized in that** said cuprate material is a rare earth metal barium cuprate material or a bismuth (lead) alkaline-earth metal copper oxide material.

4. Superconducting body according to claim 3, **characterized in that** said cuprate material is a rare earth metal barium cuprate material and further comprises strontium cations and/or calcium ions.

5. Superconducting body according to anyone of claims 1 to 4, **characterized in that** it contains aluminum cations in an amount of 2 to 100 ppm by weight, preferably of 5 to 10 ppm by weight.

6. Superconducting body according to claim 4 or 5, **characterized in that** the content of zinc cations and strontium cations, calcium cations, and/or aluminum cations amounts to maximum 1.200 ppm by weight.

7. Method for producing an oxygen-treated superconducting body, obtained by melt texturing, according to anyone of claims 1 to 6, **characterized in that** the molded body is heated at a temperature of from 300 to 570°C for from 50 to 200 hours in a pure oxygen atmosphere or in an inert gas mixture containing 0,1 to 20% by weight of oxygen, and subsequently slowly cooled.

8. Method according to claim 7, **characterized in that** the molded body is heated at a temperature of between 480 and 520°C for at least 50 hours, preferably from 100 to 200 hours, in a pure oxygen atmosphere.

9. Method according to claim 7, **characterized in that** the molded body is heated at a temperature of from 300 to 500°C in an inert gas mixture containing 0,1 to 20% by weight of oxygen.

10. Method according to claim 7, **characterized in that** the molded body is held at a temperature of 550 to 600°C for up to 100 hours prior to treatment with oxygen.

11. Superconducting body according to anyone of the preceding claims, configured as a target.

12. Process for the preparation of the superconducting material according to any one of claims 1 to 6, **characterized in that** a cuprate powder having a zinc cation content in an amount of 50 ppm to 1.000 ppm by weight and a grain size distribution d₉₀% of less than 35 µm determined by a CILAS laser granulometer, is melt textured.

13. Process according to claim 12, **characterized in that** the cuprate powder is a YBa₂Cu₃O₇₋ₓ powder or a bismuth (lead) alkaline-earth metal copper oxide powder.

14. Use of bodies according to anyone of claims 1 to 6 or produced according to anyone of claims 7 to 10, for the manufacture of superconducting cables, permanent magnets, short circuit current limiters, transformers, generators, SMES, flywheel energy storage systems, high-field magnets, electromagnets, or superconducting magnetic bearings.

## Revendications

1. Corps façonné supraconducteur obtenu par texturation en fusion, à base d'un matériau de cuprate, **caractérisé par** une teneur en cations de zinc de 50 à 5000 ppm en masse.

2. Corps supraconducteur selon la revendication 1, **caractérisé par** une teneur en cations de zinc dans la plage de 100 à 1000 ppm en masse.

3. Corps supraconducteur selon la revendication 1 ou 2, **caractérisé en ce que** le matériau de cuprate est un matériau de cuprate de baryum et de métal des terres rares ou un matériau d' oxyde de cuivre bismuth (plomb) métal alcalino-terreux.

4. Corps supraconducteur selon la revendication 3, **caractérisé en ce que**, pour autant que le matériau de cuprate est un matériau de cuprate de baryum et de métal des terres rares, il contient en outre des cations de strontium et/ou des ions de calcium.

5. Corps supraconducteur selon les revendications 1 à 4, **caractérisé en ce que** les cations d'aluminium sont contenus en une quantité de 2 à 100 ppm en masse, de préférence de 5 à 10 ppm en masse.

6. Corps supraconducteur selon la revendication 4 ou 5, **caractérisé en ce que** la teneur en cations de zinc et en cations de strontium, en cations de calcium et/ou en cations d'aluminium s'élève au maximum à 1200 ppm en masse.

7. Procédé pour la fabrication d'un corps façonné supraconducteur soumis à un traitement en présence d'oxygène, obtenu par texturation en fusion, selon les revendications 1 à 6, **caractérisé en ce que** le corps façonné est chauffé à une température de 300 à 570 °C pendant un laps de temps de 50 à 200 heures dans une atmosphère d'oxygène pur ou dans un mélange de gaz inertes qui contient de l'oxygène à concurrence de 0,1 à 20 % en poids, et le corps façonné chauffé est ensuite soumis à un lent refroidissement.

8. Procédé selon la revendication 7, **caractérisé en ce que** le corps façonné est chauffé à une température entre 480 et 520 °C pendant un laps de temps minimal de 50 heures, de préférence de 100 à 200 heures, dans une atmosphère d'oxygène pur.

9. Procédé selon la revendication 7, **caractérisé en ce que** le corps façonné est chauffé à une température de 300 à 500 °C dans un mélange de gaz inertes qui contient de l'oxygène à concurrence de 0,1 à 20 % en poids.

10. Procédé selon la revendication 7, **caractérisé en ce que** le corps façonné est maintenu, avant le traitement en présence d'oxygène, pendant un laps de temps allant jusqu'à 100 heures, à une température de 550 à 600 °C.

11. Corps supraconducteur selon l'une quelconque des revendications précédentes, réalisé sous la forme d'une cible.

12. Procédé pour la fabrication d'un matériau supraconducteur selon les revendications 1 à 6, **caractérisé en ce qu'**on soumet à une texturation en fusion une poudre de cuprate possédant une teneur en cations de zinc en une quantité de 50 ppm a 1000 ppm en masse et avec une distribution granulométrique, déterminée conformément au granulomètre laser CILAS, de d_{90%} inférieure à 35 µm.

13. Procédé selon la revendication 12, **caractérisé en ce qu'**il s'agit, en ce qui concerne la poudre de cuprate, d'une poudre de YBa₂Cu₃O₇₋ₓ ou d'une poudre d'oxyde de cuivre bismuth (plomb) métal alcalino-terreux.

14. Utilisation de corps selon l'une quelconque des revendications 1 à 6 ou fabriqués conformément à l'une quelconque des revendications 7 à 10, pour la fabrication de câbles supraconducteurs, d'aimants permanents, de limiteurs de courant de court-circuit, de transformateurs, de générateurs, de SMES, d'accumulateurs d'énergie cinétique, d'aimants à rayonnement de forte intensité, d'électro-aimants ou de paliers magnétiques supraconducteurs.
